(19) Europäisches Patentamt
European Patent Office
Office européen des brevets

(11) **EP 1 511 175 B1**

(12) **EUROPEAN PATENT SPECIFICATION**

(45) Date of publication and mention
of the grant of the patent:
**28.03.2007 Bulletin 2007/13**

(51) Int Cl.:
***H03L 7/089*** (2006.01)

(21) Application number: **04447192.8**

(22) Date of filing: **25.08.2004**

(54) **Device and method for increasing the operating range of an electrical circuit**

Vorrichtung und Verfahren zum Erhöhen des Funktionsbereichs einer elektrischen Schaltung

Appareil et procédé pour augmenter la plage de fonctionnement d'un circuit électrique

(84) Designated Contracting States:
**AT BE BG CH CY CZ DE DK EE ES FI FR GB GR HU IE IT LI LU MC NL PL PT RO SE SI SK TR**

(30) Priority: **28.08.2003 US 499286**
**08.09.2003 EP 03447224**

(43) Date of publication of application:
**02.03.2005 Bulletin 2005/09**

(73) Proprietor: **Interuniversitair Micro-Elektronica Centrum (IMEC)**
**3001 Heverlee (BE)**

(72) Inventor: **Innocent, Manuel**
**3111 Wezemaal (BE)**

(74) Representative: **Van Malderen, Joëlle et al**
**pronovem - Office Van Malderen**
**Avenue Josse Goffin 158**
**1082 Bruxelles (BE)**

(56) References cited:
**WO-A-20/04042926**      **US-A- 6 094 102**
**US-A- 6 157 821**

• **PATENT ABSTRACTS OF JAPAN vol. 1998, no. 14, 31 December 1998 (1998-12-31) -& JP 10 256903 A (MURATA MFG CO LTD), 25 September 1998 (1998-09-25)**
• **R. NADAL-GUARDIA ET AL.: "Current Drive Methods to Extend the Range of Travel of Electrostatic Microactuators Beyond the Voltage Pull-In Point" JOURNAL OF MICROELECTROMECHANICAL SYSTEMS, vol. 11, no. 3, June 2002 (2002-06), pages 255-263, XP002274234**
• **FAVRAT P ET AL: "A 1.5-V-SUPPLIED CMOS ASIC FOR THE ACTUATION OF AN ELECTROSTATIC MICROMOTOR" IEEE / ASME TRANSACTIONS ON MECHATRONICS, IEEE SERVICE CENTER, PISCATAWAY, NJ, US, vol. 2, no. 3, 1 September 1997 (1997-09-01), pages 153-160, XP000724256 ISSN: 1083-4435**

## EP 1 511 175 B1

**Description**

### Field of the invention

The present invention is related to a device and method for increasing the operating range of an electrical circuit.

### State of the art

Tunable Micro Electro-Mechanical Systems (MEMS) components appear more and more in RF circuits of wireless communication systems. They allow for new functionality or for improved performance of e.g. electrostatically tuned variable capacitors. In this way the linearity of tunable RF filters can be improved or the phase noise behaviour of voltage-controlled oscillators can be enhanced. However, the tuning voltage required by such devices is typically between 5V and 50V, which is much higher than the maximum supply voltage of a sub-micron CMOS technology. Although the required tuning voltage of these devices can be changed by design, it is unlikely to go below the rapidly decreasing supply voltage of scaled CMOS technologies. Moreover, there is a trade off between the required tuning voltage and other parameters like the mechanical resonance frequency, the electrical losses and the linearity of the device. This implies the MEMS control circuit has to generate voltages higher than the supply voltage of the rest of the system.

For the output stage of the high voltage control circuit, one can put the complete high voltage supply over the output stage. This will either require a dedicated high voltage technology like in Alcatel HBiMOS, as described in the paper "Current drive methods to extend the range of travel of electrostatic microactuators beyond the voltage pull-in point" by R. Nadal-Guardia et al. *(IEEE J. Microelectromechanical Systems,* Vol.11, No.3, pp.255-263, June 2002), or dedicated high voltage devices in an (almost) standard technology (see e.g. "A 1.5-V-supplied CMOS ASIC for the actuation of an electrostatic micromotor", P. Favrat et al., *IEEE/ASME Trans. on* Mechatronics, Vol.2, No.3, pp. 153-160, Sept. 1997). Such a dedicated high-voltage technology is often unwanted for reasons of cost.

In documents Patent Abstracts of Japan, vol.1998, no.14, 31 Dec.1998 and JP 10 256903A a PLL circuit is provided which uses a DC-DC converter to set the entire supply voltage to a low value without raising the control voltage sensitivity of a VCO. Said DC-DC converter generates a supply voltage to a charge pump and can be switched to operation when the circuit is in the non-locked state and to stop when it is in the locked state.

### Aims of the invention

The present invention aims to provide a device and method for increasing the operating range of an electrical circuit overcoming the difficulties encountered in the state of the art.

### Summary of the invention

The present invention relates to a circuit for delivering current at a voltage higher than its supply voltage comprising a first circuit, a second circuit and a high voltage generator. The first circuit is arranged for receiving at least one low voltage signal at its input and providing an output voltage signal, and the second circuit is arranged for receiving a clock signal and said output voltage signal. The second circuit further comprises means to send a request signal to the high voltage generator, which is adapted for sending two supply voltage signals to the first and the second circuit. The two supply voltage signals have a constant voltage difference. The high voltage generator comprises means for adjusting the two supply voltage signals such that the voltage of the output voltage signal falls between two reference voltage signals derived from the supply voltage signals.

In a preferred embodiment the first and the second circuit are both in a high voltage power region and the high voltage generator in a low voltage power region.

Typically a level converter is used to provide the transition between the high and the low voltage power supply region. The level converter can be implemented as a coupling capacitor.

The second circuit advantageously comprises a comparator, comparing a voltage signal derived from said output voltage signal with a reference voltage signal derived from the supply voltage signals. The comparator can be implemented as a sense amplifier latch. The second circuit may further comprise an operational transconductance amplifier.

Preferably the first circuit comprises a charge pump for a phase-locked loop.

In an alternative embodiment the first circuit comprises an operational amplifier.

The high voltage generator (HVG) preferably comprises a number of identical stages, the last of said stages being permanently clocked.

Each of said stages consists of two cells connected in parallel, one cell being adapted to pump charge up and one being adapted to pump charge down.

A circuit as described above is advantageously comprised in a Phase-Locked Loop with a MEMS variable capacitor or in a MEMS switch.

In a second object the invention relates to a method for increasing the operating range of an electrical circuit, comprising the steps of

- applying at least one low voltage signal to a first circuit, yielding an output voltage signal,
- applying a clock signal to a second circuit,
- inputting said output voltage signal into said second circuit,
- comparing said output voltage signal with two reference voltage signals, said two reference voltage signals being derived from two supply voltage signals, and if the output voltage signal does not fall between said reference voltage signals, sending a request signal to an high voltage generator in a low voltage power supply region,
- sending said two supply voltage signals from said high voltage generator to said first circuit and said second circuit, said two supply voltage signals having a constant voltage difference, and
- adjusting said two supply voltage signals such that said output voltage signal falls between the two reference voltage signals.

Advantageously the first and the second circuit are both in a high voltage power region and the high voltage generator in a low voltage power region.

In a preferred embodiment a level converter is used for the transitions between said high and said low voltage power supply region in the described method.

**Short description of the drawings**

Fig. 1 represents a general scheme, comprising a first circuit C1 and a second circuit C2 in a high-voltage supply region and a high voltage generator HVG in a low voltage supply region.

Fig. 2 represents the high supply voltage region containing the core charge pump and two sense amplifier latches.

Fig. 3 represents high voltage generator (HVG) consisting of 10 identical stages + 1 other stage.

Fig. 4 shows every stage of the high voltage generator consists of a cell that can pump charge up (top) and a cell that can pump charge down (bottom).

Fig. 5 represents the transient measurement of the low supply rail of the high voltage region.

Fig. 6 represents the measured current through an N-well to substrate junction as a function of the bias voltage for 0.18 $\mu$m CMOS.

Fig. 7 represents some simulation results.

Fig. 8 represents an embodiment of the invention as a current source.

**Detailed description of the invention**

The invention discloses a control circuit for a MEMS variable capacitor that dynamically adjusts the power supply while putting only a limited voltage over the output stage of the high voltage control circuit. It does not require any dedicated technology or devices except for a triple well, which is quite standard in nowadays CMOS processes with analogue options. The output voltage is in this case only limited by the N-well to substrate breakdown voltage. This system realises a 'power supply on demand'. It is applied to a high-voltage charge pump for use in a phase-locked loop (PLL) with a MEMS variable capacitor. Throughout this description 'charge pump' will be used in this meaning, i.e. as used in a phase-locked loop.

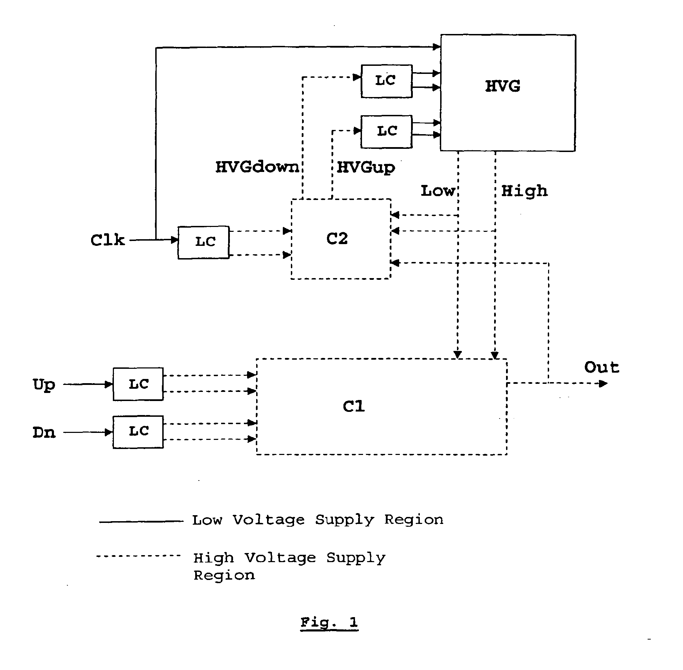

Figure 1 represents a general scheme of the control circuit. It comprises a first circuit (C1) and a second circuit (C2) both in a high voltage power supply region, and a high voltage generator (HVG) in a low voltage power supply region. The first circuit (C1) receives at its input low voltage signals (Up and Down) that have been converted to the high voltage power supply region and provides an output voltage signal (Out). The second circuit (C2) receives a (converted) clock signal Clk and said output voltage signal (Out). It further comprises means to send a request signal (HVGdown, HVGup) to the high voltage generator, that sends two supply voltage signals (High and Low) to C1 and C2.

A high voltage charge pump (HVCP) designed for use as charge pump of a PLL, has the same connections (up and down signals) as a standard charge pump. So to the system designer it acts as a standard one. It has however a large output voltage range, which is obtained by extending a standard charge pump with said power supply on demand.

The HVCP consists of two major parts: the core charge pump with sense amplifier latches in the high power supply region and the high-voltage generator (HVG) in the low supply region, with an external ground and 1.8V supply. Signals go from one region to another through a level converter (LC). The level converter can further comprise means for buffering the signals. The level converter can be a coupling capacitor. So, the two parts are in separate power supply regions and together they form a closed control loop. The goal of this loop is to keep the output voltage of the core charge pump in the middle between the high and the low power supply rail ('high' and 'low'). Both supply rails of the core charge pump region are adjusted, but their voltage difference is constant. This makes the charge pump very linear over a large voltage range, as the voltage over the output transistors is constant.

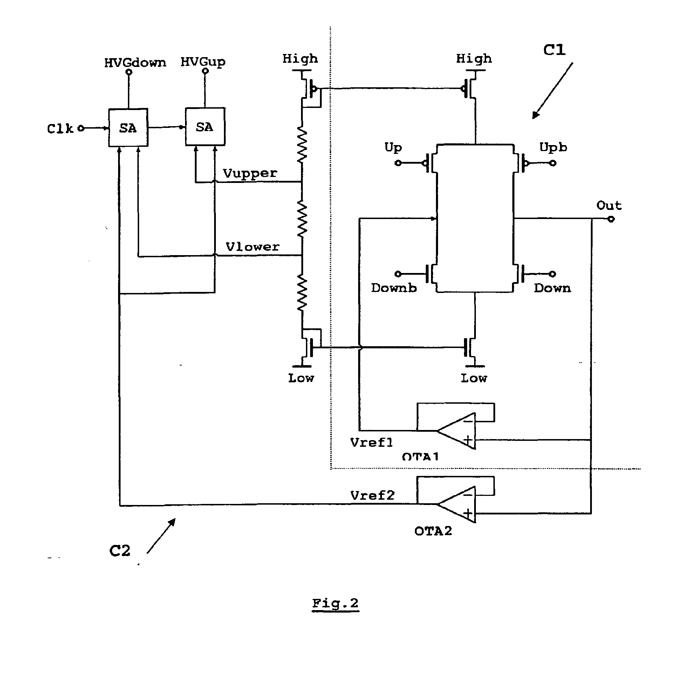

The output voltage of the charge pump (Fig. 2) is the reference to which the other voltages of the system are adjusted. It is buffered with two symmetrical operational transconductance amplifiers (OTA1 and OTA2) and then compared to two reference voltages ($V_{upper}$ and $V_{lower}$) with sense amplifier (SA) latches. The references are e.g. at 40% and 60% between the high and the low supply rail of the core charge pump. An output voltage outside this range results in a request signal (HVGup, HVGdown) to adjust the supply. For example, if the output decreases below the lower reference voltage, the supply voltages of the core charge pump ('High', 'Low') are decreased until the lower limit drops below the output again. Thus, if an output is out of range, it is not corrected by adjusting the output, but by adjusting the power supply. When the HVCP is used in a PLL the up and down signals come from the phase frequency detector. Note that in Figure 2 the two circuits, C1 and C2, are represented. The latter is used for comparing the output voltage with the two reference voltages. The former generates the output current which goes to the load, based on the input signals Up, Upb, Down and Downb. Note also Upb and Downb in Fig.2 denote the inverse signals of Up and Down, respectively.

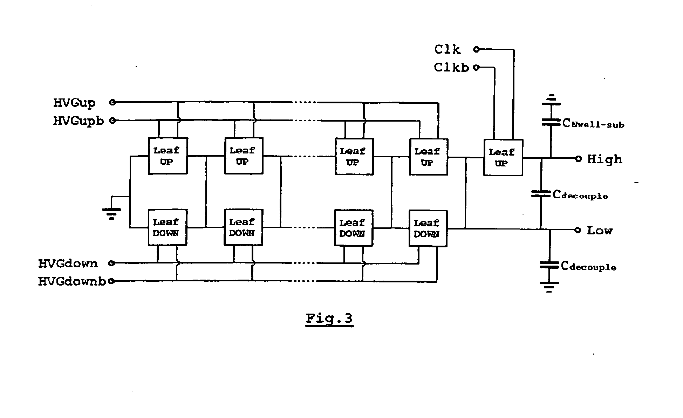

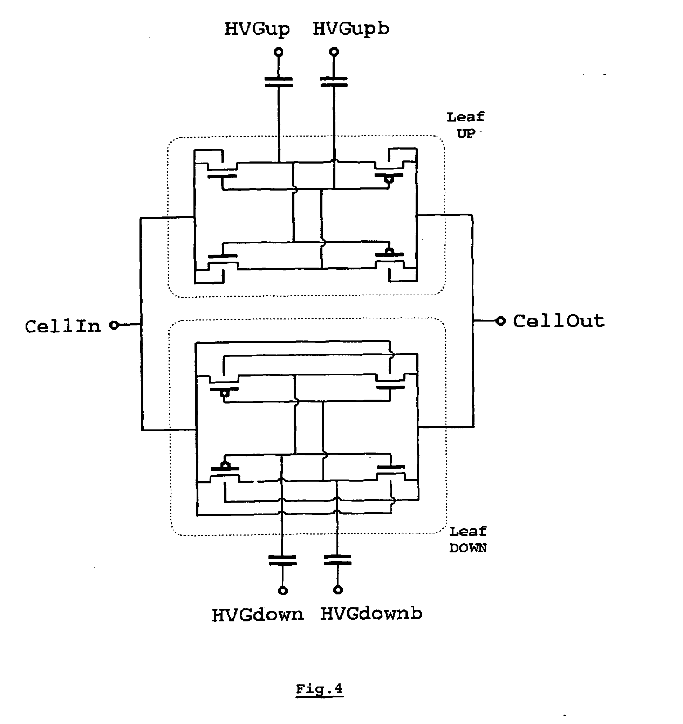

The supply voltage of the core charge pump is provided by the high voltage generator (HVG) (Fig. 3). The HVG consists of a number of identical stages that can pump charge either up or down. The last stage is permanently clocked to generate the supply of the high voltage region. The number of stages is determined by the required output voltage range and is limited by the characteristic of the N-well to substrate junction, which depends on the applied technology (cfr. infra). So, the HVG can generate voltages much higher than its own supply voltage (typically 1.8V for 0.18$\mu$m CMOS). This is often realised similarly to the high voltage generator described in "On-chip high-voltage generation in MNOS integrated circuits using an improved voltage multiplier technique", J.F.Dickson, *IEEE J.Solid-State Circuits,* Vol. 11, No.3, pp. 374-378, June 1976. However Dickson's high voltage generator can only pump charge to higher voltages. It has no means to lower the voltage again. The "power supply on demand" requires that the output voltage can both be increased and decreased. That is why a basic cell with two inverters is used like in R. Pelliconi et al., 'Power efficient charge pump in deep submicron standard CMOS technology', Proc. 27 ESSCIRC.2001, pp.100-103. The cell can be connected in reverse to pump down the charge. Every stage (Fig. 4) of the HVG consists of two basic cells connected in parallel: one to pump charge up and one to pump charge down. Each stage is located in a separate N-well, which is charged to its own output voltage.

The basic cell of the HVG consists of two capacitors and two inverters. The inverters are realised with standard low voltage transistors as none of the voltages over these transistors exceeds the supply voltage. The HVG is driven by two complementary clock signals. This simple two-phase clocking scheme allows a high clock frequency (> 50 MHz). All stages of the HVG except the last are conditionally clocked. The HVGup and HVGdown signals are the request signals coming from the core charge pump. The last stage is continuously clocked to generate the power supply of the high-voltage region.

The voltage gain $\Delta V$ over each stage has two contributions, as shown by:

$$\Delta V = V_{dd}\frac{C}{C+C_{par}} - R_{out}I_{out}, \qquad \text{(formula 1)}$$

in which the output resistance $R_{out}$ is

$$R_{out} = \frac{1}{frequency\,C} + R_{switch}. \qquad \text{(formula 2)}$$

In the first term of formula 1 the capacitance C is the coupling capacitance in the control lines (HVGup, HVGupb) and $C_{par}$ is parasitic capacitance at the internal nodes of the basic cell, not at the input and output nodes. Hence, the presence of the DOWN cell does not limit the voltage gain of the UP cell. However, the transistors of the UP cell themselves form a large part of the parasitic capacitance. This implies these transistors should be small. $V_{dd}$ denotes the supply voltage, e.g. 1.8V. The second term depends on the output current, so one has to differentiate between the final stage that generates the supply in high supply region and the intermediate stages that change the absolute voltage of that region. $R_{switch}$ denotes the resistance of the transistors when conducting. The final stage permanently supplies a current to the circuits in the high supply region, so $R_{out}$ has to be small enough to limit the voltage loss in this stage. This implies transistors with a small on-resistance and a large capacitor and/or high clock frequency. For the other stages the situation is different. If this charge pump is used to control an electrostatically tuned varicap then only the (dis)charge current of the varicap and the high supply region has to be delivered. There is no static current flowing, meaning that the maximum voltage is defined only by the capacitance ratio.

The high voltage charge pump is processed in a 0.18 $\mu$m CMOS technology. It has a pad-limited die size of 700$\mu$m*700$\mu$m, but the circuit area is only 300$\mu$m*430$\mu$m. The proposed circuit will now be shown to have a very large output voltage range and to be a low power solution scalable to future CMOS generations.

The high voltage charge pump is measured with a load capacitance $C_{load}$ of 22pF at the output and the oscilloscope connected to the low supply rail of the high voltage region. The input resistance of the oscilloscope is 1 M$\Omega$, which is too low to connect directly to the charge pump output. The table below summarises the measurement conditions.

| Supply | 1.8 V |
| --- | --- |
| Number of stages | 10+1 |
| Load | 22 pF |
| Clock frequency | 50 MHz |
| Up and Down signals | |
| Frequency | 100 kHz |
| Duty cycle | 20% |

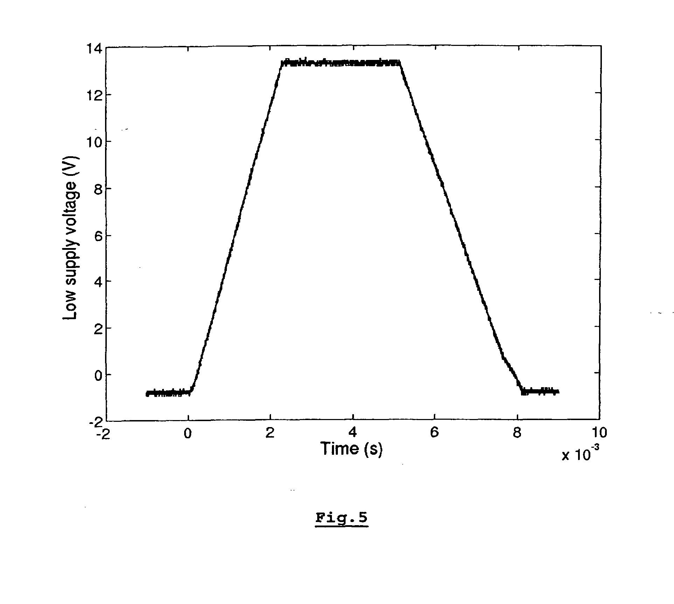

Figure 5 shows a transient measurement of the low supply rail of the high voltage region. From the transient measurement the charge pump output current can be calculated:

$$I_{out} = \frac{C_{load}}{DutyCycle} \frac{\Delta V}{\Delta t}, \qquad \text{(formula 3)}$$

The charge pump is very linear. The output current is constant over the complete voltage range. The current consumption depends strongly on the operating regime. The maximum current of 1 mA is drawn when the output is limited by conduction or breakdown of the N-well to substrate junction. In normal operation this is also the maximum current that can occur during transients. In steady state, with a 50 MHz clock signal, but without up or down pulses, the current is only 85 $\mu$A and the leakage current is so small that no difference in output voltage could be measured after 1 second. In a PLL in lock, the up and down pulses are very small so that the current consumption will be very close to this 85 $\mu$A, so this can be regarded as a low power solution. When the clock is also turned off, the supply current drops to only a few nA.

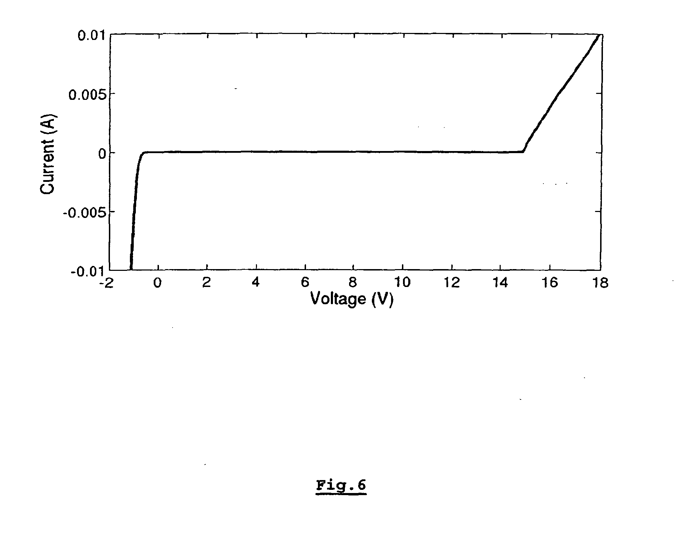

The high voltage generator has 10+1 stages and a supply of 1.8V, so the theoretical maximum output voltage (without parasitic capacitances) is 19.8V. However, the measurement shows only 13.2V at the 'Low' node plus 1.6V over the final stage, which is only 14.8V. This difference is larger than what is expected based on the parasitic capacitance, but it is explained by the characteristics of the N-well to substrate junction. The high supply voltage region is inside an N-well, which is charged to the high supply rail of this region. The highest possible voltage in the system is the breakdown voltage of the well to substrate junction, which is 14.8V for the used technology (Fig. 6). Any attempt to charge the well to a higher voltage results in charge flowing away to the substrate. As the breakdown voltage poses the fundamental limit on the output voltage we checked it for several technologies. The results are all in the same range e.g. 16.2V for a 0.35 $\mu$m BiCMOS technology and 17.5V and 18.5V volts for two flavours of 0.09 $\mu$m CMOS technology. This shows that the circuit can be used in future technologies. Table 2 summarises the measurement results.

| Output current | 0.7 $\mu$A |
| --- | --- |
| Supply current max | 1.0 mA |
| Supply current idle (50 MHz clock) | 85 $\mu$A |
| Supply current leakage (no clock) | 2.5 nA |
| Voltage range (at "Low" node) | -0.7...+13.2 V |

(continued)

| Voltage range (at output) | -0.7...+14.8 V |
| --- | --- |

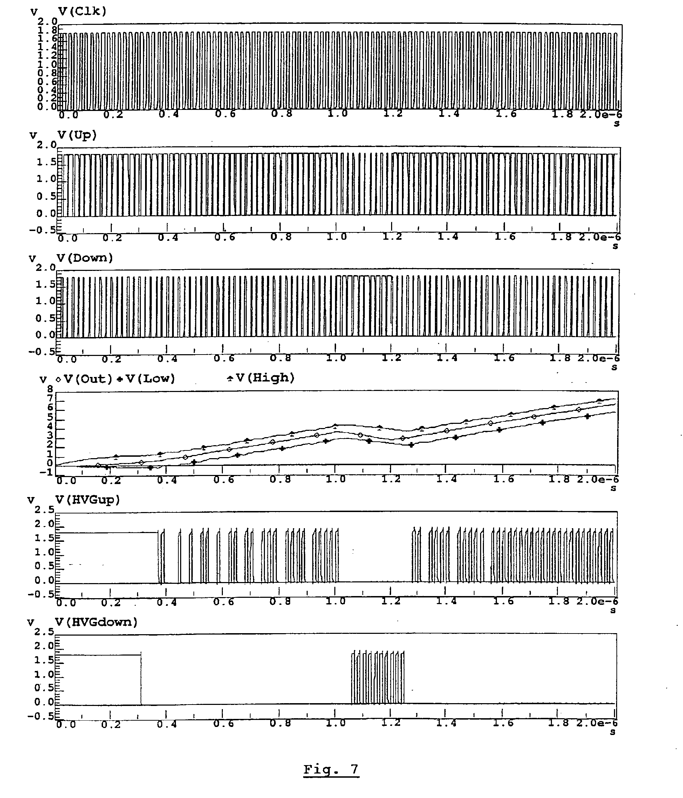

Some simulation results are shown in Fig.7. The upper three graphs show the input signals:

1) V(Clk) represents the clock signal, being a 50 MHz square wave with 50% duty cycle.

2) V(Up) is the Up signal, a pulse width modulated signal. The wider the Up pulses, the longer the output current will flow towards the load (MEMS capacitor). In this simulation the Up pulses are wide, except for the time between 1.0us and 1.2us where they are narrow.

3) V(Down) is the Down signal, a pulse width modulated signal. The wider the Down pulses, the longer the current will flow from the load (MEMS capacitor) into the output. In this simulation the Down pulses are narrow, except for the time between 1.0us and 1.2us where they are wide.
The combination of the Up and Down pulses will cause a current flow towards the load, except for the time between 1.0us and 1.2us, when the current will flow from the load into the output.
The lower three graphs show internal and the output signal.

4) V(Out) is the output voltage, i.e. the voltage over the load. V(Low) is the low supply voltage of the high voltage power supply region. V(High) is the high supply voltage of the high voltage power supply region.

5) V(HVGup) is the request signal to the HVG to increase both supply voltages of the high voltage power supply region.

6) V (HVGdown) is the request signal to the HVG to decrease both supply voltages of the high voltage power supply region.
After the startup transients are finished, the difference between V(Low) and V(High) is constantly 1.8V. The HVGup gets a pulse whenever V(Out) approaches to close to V(High), similarly the HVGdown gets a pulse whenever V (Out) approaches to close to V(Low). V (High) and V (Low) are adjusted such that the output stays approximately in the middle between them. The adjustment is done based on the request signals V(HVGup) and V(HVGdn).

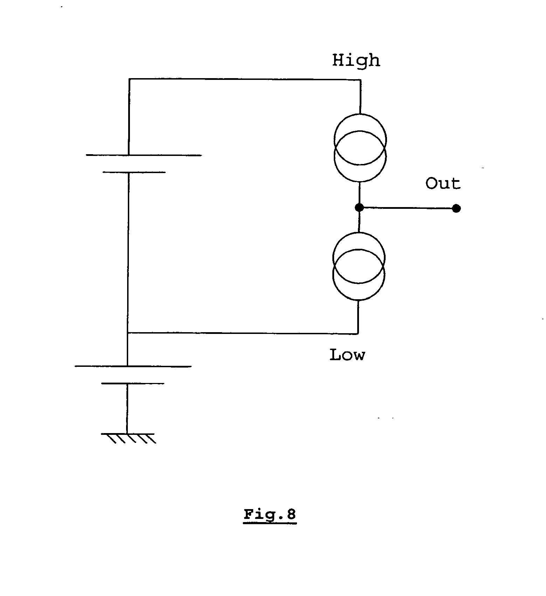

In another object the invention discloses a current source able to deliver current at a voltage higher than its supply voltage. This is illustrated in Fig.8. The voltage sources in fact represent the high voltage generator. The voltage source at the top corresponds to the last cell shown in Fig. 3. The voltage source at the bottom corresponds to the 10 identical HVG cells of Fig.3. Circuit C1 (as in Fig.2) is represented by the two current sources. The bottom voltage source is regulated such that the output voltage is between the voltages on the two sides of the top voltage source. The feedback circuit that performs this regulation is not shown in Fig.8.

## Claims

1. Circuit comprising a first circuit (C1) and a second circuit (C2) and a high voltage generator (HVG), said first circuit (C1) being arranged for receiving at least one low voltage signal at its input and providing an output voltage signal (Out), said second circuit (C2) being arranged for receiving a clock signal (Clk) and said output voltage signal (Out), said second circuit (C2) further comprising means to send a request signal (HVGdown, HVGup) to said high voltage generator (HVG), said high voltage generator being adapted for sending two supply voltage signals to said first circuit (C1) and said second circuit (C2), said two supply voltage signals (High, Low) having a constant voltage difference, said high voltage generator further comprising means for adjusting said two supply voltage signals (High, Low) such that the voltage of said output voltage signal (Out) falls between two reference voltage signals (Vupper, Vlower) derived from said supply voltage signals (High, Low).

2. Circuit as in claim 1, wherein said first circuit (C1) and said second circuit (C2) are both in a high voltage power region and said high voltage generator (HVG) in a low voltage power region.

3. Circuit as in claim 2, wherein a level converter (LC) is used to provide the transition between said high and said low voltage power supply region.

**4.** Circuit as in claim 3, **characterised in that** said level converter (LC) is a coupling capacitor.

**5.** Circuit as in any of claims 1 to 4, **characterised in that** said second circuit (C2) comprises a comparator, comparing a voltage signal derived from said output voltage signal (Out) with a reference voltage signal derived from said supply voltage signals (High, Low).

**6.** Circuit as in claim 5, **characterised in that** said comparator is a sense amplifier latch (SA).

**7.** Circuit as in any of claims 1 to 6, **characterised in that** said second circuit (C2) further comprises an operational transconductance amplifier (OTA2).

**8.** Circuit as in any of the previous claims, **characterised in that** said first circuit (C1) comprises a charge pump for a phase-locked loop.

**9.** Circuit as in any of claims 1 to 7, **characterised in that** said first circuit (C1) comprises an operational amplifier.

**10.** Circuit as in any of claims 1 to 9, **characterised in that** said high voltage generator (HVG) comprises a number of identical stages, the last of said stages being permanently clocked.

**11.** Circuit as in claim 10, **characterised in that** each of said stages consists of two cells connected in parallel, one cell being adapted to pump charge up and one being adapted to pump charge down.

**12.** Phase-Locked Loop with a MEMS variable capacitor comprising a circuit as in any of claims 1 to 11.

**13.** MEMS switch comprising a control circuit as in any of claims 1 to 11.

**14.** Method for increasing the operating range of an electrical circuit comprising the steps of

- applying at least one low voltage signal to a first circuit (C1), yielding an output voltage signal (Out),
- applying a clock signal (Clk) to a second circuit (C2),
- inputting said output voltage signal into said second circuit (C2),
- comparing said output voltage signal (Out) with two reference voltage signals (Vupper, Vlower), said two reference voltage signals being derived from two supply voltage signals (High, Low), and if said output voltage signal (Out) does not fall between said reference voltage signals (Vupper, Vlower), sending a request signal (HVGdown, HVGup) to an high voltage generator (HVG) in a low voltage power supply region,
- sending said two supply voltage signals (High, Low) from said high voltage generator (HVG) to said first circuit (C1) and said second circuit (C2), said two supply voltage signals (High, Low) having a constant voltage difference,
- adjusting said two supply voltage signals (High, Low) such that said output voltage signal (Out) falls between said two reference voltage signals (Vupper, Vlower).

**15.** Method of claim 14, **characterised in that** said first circuit (C1) and said second circuit (C2) are both in a high voltage power region and said high voltage generator (HVG) in a low voltage power region.

**16.** Method of claim 15, **characterised in that** a level converter is used for the transitions between said high and said low voltage power supply region.

**Patentansprüche**

**1.** Schaltkreis, umfassend einen ersten Schaltkreis (C1) und einen zweiten Schaltkreis (C2) und einen Hochspannungs-Generator (HVG), wobei der besagte erste Schaltkreis (C1) zur Aufnahme von wenigstens einem Niederspannungs-Signal an seinem Eingang und zur Lieferung eines Austritts-Spannungssignals (Out) ausgelegt ist, wobei der besagte zweite Schaltkreis (C2) zur Aufnahme eines Taktsignals (Clk) und des besagten Austritts-Spannungssignals (Out) ausgelegt ist, wobei der besagte zweite Schaltkreis (C2) des Weiteren Mittel umfasst, um ein Abrufsignal (HVGdown, HVGup) an besagten Hochspannungs-Generator (HVG) zu senden, wobei besagter Hochspannungs-Generator angepasst ist, um zwei Netzspannungs-Signale an besagten ersten Schaltkreis (C1) und an besagten zweiten Schaltkreis (C2) zu senden, wobei besagte zwei Netzspannungs-Signale (High, Low) eine konstante Spannungsdifferenz aufweisen, wobei besagter Hochspannungs-Generator des Weiteren Mittel zur Einstellung der besagten zwei Netzspannungs-Signale (High, Low) umfasst, derart dass die Spannung des besagten Austritts-Spannungssignals (Out) zwischen zwei, von den besagten Netzspannungs-Signalen (High, Low) abgeleiteten Referenzspannungs-Signalen (Vupper, Vlower) fällt.

2. Schaltkreis gemäß Anspruch 1, wobei besagter erster Schaltkreis (C1) und besagter zweiter Schaltkreis (C2) sich beide in einem Hochspannungs-Leistungsbereich befinden, und besagter Hochspannungs-Generator (HVG) sich in einem Niederspannungs-Leistungsbereich befindet.

3. Schaltkreis gemäß Anspruch 2, wobei ein Pegelkonverter (LC) gebraucht wird, um den Übergang zwischen besagtem Hochspannungs- und besagtem Niederspannungs-Leistungsbereich zu liefern.

4. Schaltkreis gemäß Anspruch 3, **dadurch gekennzeichnet, dass** besagter Pegelkonverter (LC) ein Koppelkondensator ist.

5. Schaltkreis gemäß irgendeinem der Ansprüche 1 bis 4, **dadurch gekennzeichnet, dass** besagter zweiter Schaltkreis (C2) einen Vergleicher umfasst, um ein von besagtem Ausgangs-Spannungssignal (Out) abgeleitetes Spannungssignal mit einem von besagten Netzspannungs-Signalen (High, Low) abgeleiteten Referenz-Spannungssignal zu vergleichen.

6. Schaltkreis gemäß Anspruch 5, **dadurch gekennzeichnet, dass** besagter Vergleicher ein Leseverstärkerlatch (SA) ist.

7. Schaltkreis gemäß irgendeinem der Ansprüche 1 bis 6, **dadurch gekennzeichnet, dass** besagter zweiter Schaltkreis (C2) des Weiteren einen Transduktions-Operationsverstärker (OTA2) umfasst.

8. Schaltkreis gemäß irgendeinem der vorhergehenden Ansprüche, **dadurch gekennzeichnet, dass** besagter erster Schaltkreis (C1) eine Ladungspumpe für eine Phasenregelschleife umfasst.

9. Schaltkreis gemäß irgendeinem der Ansprüche 1 bis 7, **dadurch gekennzeichnet, dass** besagter erster Schaltkreis (C1) einen Operationsverstärker umfasst.

10. Schaltkreis gemäß irgendeinem der Ansprüche 1 bis 9, **dadurch gekennzeichnet, dass** besagter Hochspannungsgenerator (HVG) eine Anzahl von identischen Stufen umfasst, wobei die letzte von besagten Stufen dauernd getaktet ist.

11. Schaltkreis gemäß Anspruch 10, **dadurch gekennzeichnet, dass** jede der besagten Stufen aus zwei parallel geschalteten Zellen besteht, wobei eine der Zellen ausgelegt ist, um die Ladung aufzupumpen und eine, um die Ladung abzupumpen.

12. Phasenregelschleife mit einem MEMS veränderlichen Kondensator, welcher einen Schaltkreis wie in irgendeinem der Ansprüche 1 bis 11 umfasst.

13. MEMS Schalter, welcher einen Steuerkreis wie in irgendeinem der Ansprüche 1 bis 11 umfasst.

14. Verfahren zur Erweiterung des Betriebsbereiches eines elektrischen Schaltkreises, welches die Schritte umfasst

  • Anbringen von wenigstens einem Niederspannungs-Signal an einen ersten Schaltkreis (C1), zur Lieferung eines Austritts-Spannungssignals (Out),
  • Anbringen eines Taktsignals (Clk) an einen zweiten Schaltkreis (C2),
  • Eingabe von besagtem Austritts-Spannungssignal in besagten zweiten Schaltkreis (C2),
  • Vergleich des besagten Austritts-Spannungssignals (Out) mit zwei Referenzspannungs-Signalen (Vupper, Vlower), wobei besagte zwei Referenzspannungs-Signale von zwei Netzspannungs-Signalen (High, Low) abgeleitet werden, und falls besagtes Austritts-Spannungssignal (Out) nicht zwischen besagte Referenzspannungs-Signale (Vupper, Vlower) fällt, Senden eines Abrufsignals (HVGdown, HVGup) an einen Hochspannungsgenerator (HVG) in einem Niederspannungs-Leistungsbereich,
  • Senden der besagten zwei Netzspannungs-Signale (High, Low) von besagtem Hochspannungs-Generator (HVG) an besagten ersten Schaltkreis (C1) und an besagten zweiten Schaltkreis (C2), wobei besagte zwei Netzspannungs-Signale (High, Low) eine konstante Spannungsdifferenz aufweisen,
• Einstellung von besagten zwei Netzspannungs-Signalen (High, Low), derart dass besagtes Austritts-Spannungssignal (Out) zwischen die besagten zwei Referenzspannungs-Signale (Vupper, Vlower) fällt.

**15.** Verfahren gemäß Anspruch 14, **dadurch gekennzeichnet, dass** besagter erster Schaltkreis (C1) und besagter zweiter Schaltkreis (C2) beide in einem Hochspannungs-Leistungsbereich liegen und besagter Hochspannungs-Generator (HVG) in einem Niederspannungs-Leistungsbereich liegt.

**16.** Verfahren gemäß Anspruch 15, **dadurch gekennzeichnet, dass** ein Pegelkonverter für die Übergänge zwischen besagtem Hochspannungs-Leistungsbereich und besagtem Niederspannungs-Leistungsbereich benützt wird.

## Revendications

**1.** Circuit comprenant un premier circuit (C1) et un deuxième circuit (C2) ainsi qu'un générateur de haute tension (HVG), ledit premier circuit (C1) étant aménagé pour recevoir au moins un signal de basse tension à son entrée et pour fournir un signal de tension de sortie (Out), ledit deuxième circuit (C2) étant aménagé pour recevoir un signal d'horloge (Clk) et ledit signal de tension de sortie (Out), ledit deuxième circuit (C2) comprenant en outre des moyens pour envoyer un signal de demande (HVGdown, HVGup) vers ledit générateur de haute tension (HVG), ledit générateur de haute tension étant adapté pour envoyer deux signaux de tension d'alimentation vers ledit premier circuit (C1) et vers ledit deuxième circuit (C2), lesdits deux signaux de tension d'alimentation (High, Low) ayant une différence de tension constante, ledit générateur de haute tension comprenant en outre des moyens pour ajuster lesdits deux signaux de tension d'alimentation (High, Low) de façon telle que la tension dudit signal de tension de sortie (Out) tombe entre deux signaux de tension de référence (Vupper, Vlower) dérivés desdits signaux de tension d'alimentation (High, Low).

**2.** Circuit selon la revendication 1, dans lequel ledit premier circuit (C1) et ledit deuxième circuit (C2) sont tous les deux dans une plage de puissance à haute tension et ledit générateur de haute tension (HVG) dans une plage de puissance à basse tension.

**3.** Circuit selon la revendication 2, dans lequel un convertisseur de niveaux (LC) est utilisé pour fournir la transition entre ladite plage d'alimentation de puissance à haute tension et ladite plage d'alimentation de puissance à basse tension.

**4.** Circuit selon la revendication 3, **caractérisé en ce que** ledit convertisseur de niveaux (LC) est un condensateur de couplage.

**5.** Circuit selon l'une quelconque des revendications 1 à 4, **caractérisé en ce que** ledit deuxième circuit (C2) comprend un comparateur, comparant un signal de tension dérivé dudit signal de tension de sortie (Out) à un signal de tension de référence dérivé desdits signaux de tension d'alimentation (High, Low).

**6.** Circuit selon la revendication 5, **caractérisé en ce que** ledit comparateur est un latch d'amplificateur de lecture (SA).

**7.** Circuit selon l'une quelconque des revendications 1 à 6, **caractérisé en ce que** ledit deuxième circuit (C2) comprend en outre un amplificateur de transductance opérationnel (OTA2).

**8.** Circuit selon l'une quelconque des revendications précédentes, **caractérisé en ce que** ledit premier circuit (C1) comprend une pompe de charge pour une boucle à verrouillage de phase.

**9.** Circuit selon l'une quelconque des revendications 1 à 7, **caractérisé en ce que** ledit premier circuit (C1) comprend un amplificateur opérationnel.

**10.** Circuit selon l'une quelconque des revendications 1 à 9, **caractérisé en ce que** ledit générateur de haute tension (HVG) comprend un nombre d'étages identiques, le dernier desdits étages étant en permanence cadencé par horloge.

**11.** Circuit selon la revendication 10, **caractérisé en ce que** chacun desdites étages consiste en deux cellules connectées en parallèle, une cellule étant adaptée pour gonfler la charge et l'autre cellule étant adaptée pour évacuer la charge.

12. Boucle à verrouillage de phase avec un condensateur variable MEMS, comprenant un circuit tel que dans l'une quelconque des revendications 1 à 11.

13. Commutateur MEMS comprenant un circuit de commande tel que dans l'une quelconque des revendications 1 à 11.

14. Procédé pour augmenter la plage de fonctionnement d'un circuit électrique, comprenant les étapes consistant à :

    • appliquer au moins un signal de basse tension à un premier circuit (C1), générant un signal de tension de sortie (Out),
    • appliquer un signal d'horloge (Clk) à un deuxième circuit (C2),
    • faire entrer ledit signal de tension de sortie dans ledit deuxième circuit (C2),
    • comparer ledit signal de tension de sortie (Out) à deux signaux de tension de référence (Vupper, Vlower), lesdits deux signaux de tension de référence étant dérivés de deux signaux de tension d'alimentation (High, Low), et, si ledit signal de tension de sortie (Out) ne tombe pas entre lesdits signaux de tension de référence (Vupper, Vlower), envoyer un signal de demande (HVGdown, HVGup) à un générateur de haute tension (HVG) dans une plage d'alimentation de puissance à basse tension,
    • envoyer lesdits deux signaux de tension d'alimentation (High, Low) dudit générateur de haute tension (HVG) vers ledit premier circuit (C1) et ledit deuxième circuit (C2) , lesdits deux signaux de tension d'alimentation (High, Low) ayant une différence de tension constante,
    • ajuster lesdits deux signaux de tension d'alimentation (High, Low) de façon telle que ledit signal de tension de sortie (Out) tombe entre lesdits deux signaux de tension de référence (Vupper, Vlower).

15. Procédé selon la revendication 14, **caractérisé en ce que** ledit premier circuit (C1) et ledit deuxième circuit (C2) sont tous les deux dans une plage de puissance à haute tension et ledit générateur à haute tension (HVG) dans une plage de puissance à basse tension.

16. Procédé selon la revendication 15, **caractérisé en ce qu'**un convertisseur de niveaux est utilisé pour les transitions entre ladite plage d'alimentation de puissance à haute tension et ladite plage d'alimentation de puissance à basse tension.

Fig. 1

——————— Low Voltage Supply Region

- - - - - - - - - High Voltage Supply
Region

Fig.2

**Fig.3**

HVGup     HVGupb

Leaf
UP

CellIn                                    CellOut

Leaf
DOWN

HVGdown   HVGdownb

Fig.4

**Fig.5**

**Fig.6**

Fig. 7

17

High

Out

Low

**Fig.8**